# EUROPÄISCHE PATENTSCHRIFT

(11) **EP 3 615 706 B1**
(45) Veröffentlichungstag und Bekanntmachung des Hinweises auf die Patenterteilung: **13.10.2021**
(21) Anmeldenummer: 18720242.9
(22) Anmeldetag: 26.04.2018
(51) Int. Cl.: C23C 16/04, C23C 16/455, C23C 16/50, C23C 16/40, C23C 16/511, H01J 37/32

(54) **VORRICHTUNG ZUR INNENBESCHICHTUNG VON BEHÄLTERN**
DEVICE FOR INTERNALLY COATING CONTAINERS
DISPOSITIF POUR L'APPLICATION D'UN REVÊTEMENT INTERNE SUR DES CONTENANTS

(30) Priorität: 26.04.2017 DE 102017108992
(43) Veröffentlichungstag der Anmeldung: 04.03.2020
(73) Patentinhaber: KHS Corpoplast GmbH, 22145 Hamburg (DE)
(72) Erfinder: KYTZIA, Sebastian, 23826 Todesfelde (DE); KEMPA, Bernd-Thomas, 22145 Hamburg (DE); LANGHAMMER, Philipp, 22397 Hamburg (DE); VOGELSANG, Andreas, 22145 Hamburg (DE)
(74) Vertreter: DTS Patent- und Rechtsanwälte Schnekenbühl und Partner mbB
(86) Internationale Anmeldenummer: PCT/EP2018/060648
(87) Internationale Veröffentlichungsnummer: WO 2018/197591

(56) Entgegenhaltungen:
- DE-A1-102006 044 624
- DE-A1-102012 201 955
- US-A1- 2002 136 909
- US-A1- 2009 120 363

## Beschreibung

Es besteht derzeit ein zunehmender Trend dahin, Behälter, z.B. PET-Flaschen, innen zu beschichten, z.B. mit einer dünnen SiOx-Schicht. Diese Innenbeschichtung wird in einer Beschichtungsvorrichtung durchgeführt, welche eine Vakuumkammer zur Aufnahme des Behälters aufweist. Die Vorrichtung enthält weiterhin einen Plasmagenerator, zum Beispiel einen Mikrowellengenerator, und eine Gaslanze mit einer in den Behälter ragenden Austrittsöffnung zur Einbringung eines auf der Innenwand des Behälters abzuscheidenden Materials. Zum Beispiel wird ein Prozessgas, wie bspw. Siloxan-Gas in den Behälter eingeführt, welches sich, in dem durch den Plasmagenerator gebildeten Plasma, dann in Form von SiOx-Schichten auf der Innenwand des Behälters abscheidet. Solche Beschichtungsvorrichtungen sind bekannt aus der DE 10 2010 023119 A1 oder aus der EP 1 507 893 B1. Aus der DE 10 2012 201 955 A1 ist es darüber hinaus bekannt, dass die rohrförmige Gaslanze einer oben beschriebene Vorrichtung zusätzlich zu einer Vielzahl von Bohrungen mit Durchmessern im Sub-Millimeter-Bereich, die in ihrem Mantel ausgebildet sind und durch die Prozessgas austreten kann, an ihrem Ende ebensolche Bohrungen mit Durchmessern im Sub-Millimeter-Bereich aufweist. Anstatt der Bohrungen sind dort auch Aussparungen vorgesehen, die eine mittlere Größe von bis zu 10 mm haben.

Nun ist zu beachten, dass im Bereich der Getränkeindustrie eine derartige Beschichtungsvorrichtung einen erheblichen Durchsatz hat. So können an einem Tag Zehntausende von Flaschen und pro Stunde mehrere tausend Flaschen beschichtet werden. Ein Problem in einer derartigen Vorrichtung besteht nun darin, dass sich die Austrittsöffnung der Gaslanze relativ schnell durch Beschichtung zuwächst. Dies erfordert eine häufige Reinigung bzw. öfteren Austausch der Gaslanze.

Es ist daher Aufgabe der Erfindung, eine Beschichtungsvorrichtung zu schaffen, bei der der Wartungs- und Reinigungsaufwand reduziert ist.

Diese Aufgabe wird gelöst mit einer Beschichtungsvorrichtung gemäß Anspruch 1. Vorteilhafte Weiterbildungen der Erfindung sind Gegenstand der zugeordneten Unteransprüche. Vorteilhafte Ausführungsformen der Erfindung sind weiterhin in der Beschreibung und in den Zeichnungen ausgeführt.

Erfindungsgemäß ist der Innendurchmesser der Gaslanze im Bereich der Austrittsöffnung relativ zu dem Innendurchmesser eines Hauptabschnitts der Gaslanze vergrößert. Die Gaslanze hat dabei eine Mehrfachfunktion, indem über diese die Zuleitung der jeweiligen Prozessgase für die Beschichtung erfolgt, und weiterhin dient diese Gaslanze als Antenne für die elektromagnetische Feldorientierung in der Vakuumkammer. Bei einer alternativen Ausführungsform kann über die Gaslanze auch zumindest eine Teilmenge des Gases aus dem Behälter und/oder der Vakuumkammer abgesaugt werden, sowie das Entspannungsgas, in der Regel Luft, eingeleitet werden. Der Hauptabschnitt bildet den überwiegenden Teil der Länge der Gaslanze, vorzugsweise mehr 50%, insbesondere mehr als 90% der Länge der Gaslanze. In diesem Hauptabschnitt ist der Innendurchmesser der Gaslanze vorzugsweise konstant, d.h. ein definierter Wert.
,

Die Austrittsöffnung wird durch die Erfindung größer gegenüber der herkömmlichen Gaslanze, bei welcher die Größe der Austrittsöffnung bislang allein durch den Innendurchmesser der Gaslanze definiert war. Durch die vergrößerte Austrittsöffnung neigt das austretende Prozessgas, wie bspw. Siloxan beim Austreten aus der Gaslanze und Eintreten in das Plasma wesentlich weniger zur Abscheidung von SiOx-Schichten an der die Austrittsöffnung umgebenden Endkante der Gaslanze.

Da sich die Gaslanze im Raum des Beschichtungsprozesses befindet, ist sie dem Mikrowellenfeld in der Vakuumkammer ausgesetzt. Dadurch entstehen auf der Austrittsseite am bspw. zylindrischen Rohrend Feldüberhöhungen bzw. Feldkonzentrationen, die ein bevorzugtes Abscheiden von Prozessprodukten, wie SiOx und damit ein Anwachsen von Schichten begünstigt. Dieser Beschichtungsvorgang führt nach relativ kurzer Zeit zu einer Verringerung der Austrittsöffnung bzw. des Austrittquerschnitts, sodass die idealen Strömungsverhältnisse des Gasgemisches nicht mehr gegeben sind und die Beschichtungswerte nicht mehr erreicht werden.

Die elektromagnetische Feldorientierung und Feldkonzentration ist in der aufgeweiteten Öffnung massiv reduziert. Zusätzlich kommt hinzu, dass die Tendenz des Prozessgases, an der Außenkante der Gaslanze reduzierte Verwirbelungen bilden, die sehr viel geringer als bei herkömmlichen zylindrischen Gaslanzen mit konstantem Innendurchmesser ist. Aufgrund der Tatsache, dass die Austrittsöffnung aufgeweitet ist, ist somit die Neigung zur Bildung von Ablagerungen, wie im Falle des Siloxans von SiOx-Schichten, an der die Austrittsöffnung umgebenden Endkante der Gaslanze wesentlich geringer als bei den bisherigen Gaslanzen. Etwaige sich in geringerem Maße nach wie vor an der Endkante absetzende Ablagerungen führen somit nicht so schnell zu einer Verkleinerung der Austrittsöffnung. Die Service-Intervallzeiten zur Reinigung der Austrittsöffnung bzw. zum Austausch der Gaslanze können somit beträchtlich verlängert werden.

Erfindungungsgemäß ist die Gaslanze im Bereich der Austrittsöffnung trompetenförmig aufgeweitet. Auf diese Weise nimmt der Innendurchmesser der Gaslanze im Bereich der Austrittsöffnung kontinuierlich zunehmend zu, so dass keine Kante auftritt an der Verwirbelungen auftreten können. Zudem gerät die Endkante durch die Aufweitung der Austrittsöffnung aus dem direkten Strahlbereich des mittels der Gaslanze in den Behälter eingeblasenen Gases. Somit wird die Tendenz zur Anlagerung von SiOx-Schichten an der Außenkante der Gaslanze im Bereich der Austrittsöffnung äußerst stark reduziert, was erheblich größere Serviceintervalle zur Reinigung der Gaslanze mit sich bringt. Es ist hierbei letztlich unerheblich, ob die Aufweitung des Innendurchmessers der Gaslanze auch mit einer Vergrößerung ihres Außendurchmessers verbunden ist. Wenn dies der Fall ist, kann die Aufweitung des Innendurchmesser auf jeden Fall in einem Maße durchgeführt werden, der über die Wandstärke der Gaslanze hinausgeht (dies wäre die Einschränkung in der Zunahme des Innendurchmessers, wenn der Außendurchmesser der Gaslanze konstant bliebe). Die trompetenförmige Aufweitung hat den Vorteil, dass keine Kanten an der Innenfläche der Gaslanze vorhanden sind, an welchen sich SiOx-Schichten absetzen könnten.

In einer dazu alternativen Ausführungsform kann die Gaslanze im Bereich der Austrittsöffnung auch kegelförmig aufgeweitet sein. Eine derartige Ausführungsform ist leichter herstellbar auch wenn sie strömungstechnisch nicht ganz so günstig ist wie eine trompetenförmig aufgeweitete Gaslanze.

Erfindungungsgemäß ist der Innendurchmesser der Gaslanze im Bereich der Austrittsöffnung gegenüber dem Innendurchmesser in einem Hauptabschnitt der Gaslanze erweitert sein, d.h. z.B. als erweiterter zylindrischer Abschnitt. Es kann auch eine Reduzierung der Wandstärke der Gaslanze vorliegen. Die ist sehr kostengünstig herstellbar. Diese Ausführungsform kann mit der trompetenförmigen oder kegelförmigen Aufweitung der Gaslanze im Bereich der Austrittsöffnung kombiniert sein. Prinzipiell ist ein rein größerer Innendurchmesser der Gaslanze im Bereich der Austrittsöffnung gegenüber dem Innendurchmesser in einem Hauptabschnitt der Gaslanze bereits ausreichend, um die Tendenz der unerwünschten Anlagerung an der Austrittsöffnung zu verringern.

Wenn hier von dem Bereich der Austrittsöffnung der Gaslanze gesprochen wird, bezieht sich dies auf den Endabschnitt der Gaslanze, z.B. die letzten 5 cm, insbesondere die letzten 3 cm vor der Austrittsöffnung.

Vorzugsweise besteht die Gaslanze im Bereich der Austrittsöffnung aus einem anderen Material als in einem Hauptabschnitt. Auf diese Weise kann zum Beispiel ein Material gewählt werden, bei dem die Tendenz zur Anlagerung im Plasmaprozess reduziert ist. Ein derartiges Material ist zum Beispiel eine Al₂O₃-haltige Keramik.

Vorzugsweise besteht die Gaslanze zumindest teilweise aus Edelstahl und/oder zumindest teilweise aus Al₂O₃. Diese beiden Materialien haben sich zur Herstellung von Gaslanzen bewährt.

Vorteilhafterweise ist die Gaslanze mehrteilig, mit einem Hauptabschnitt, der die größere axiale Länge der Gaslanze bildet und einem axial kürzeren Endabschnitt, in dem die Austrittsöffnung angeordnet ist. Auf diese Weise kann der Endabschnitt der Gaslanze im Bereich der Austrittsöffnung vorzugsweise auswechselbar an dem Hauptabschnitt der Gaslanze gehalten sein. Auf diese Weise kann der Endabschnitt oder die Spitze der Gaslanze leicht ausgewechselt werde, wenn eine Reinigung des die Austrittsöffnung aufweisenden Endabschnitts nicht mehr möglich ist. Somit muss nicht die gesamte Gaslanze ausgewechselt werden, was ökonomisch günstig ist. Die Verbindung zwischen dem Hauptabschnitt und dem Endabschnitt erfolgt beispielweise über Friktion oder andere an sich bekannte lösbar Verbindungstechniken (Gewinde, Bajonett etc.).

Vorzugsweise weist die Gaslanze an der Austrittsöffnung einen Innendurchmesser auf, der wenigstens zweimal so groß, insbesondere dreimal so groß ist, wie der Innendurchmesser im Hauptabschnitt der Gaslanze. Wenn in dieser Anmeldung von einem Hauptabschnitt der Gaslanze gesprochen wird, so bezieht sich dies auf den axial größten Teil der Gaslanze, der vorzugsweise einen konstanten Innendurchmesser aufweist. Dieser Hauptabschnitt bildet somit den überwiegenden Teil der Gaslanze, der beim Beschichtungsprozess ganz oder teilweise in die Flasche hineinragt.

Vorzugsweise ist der Endabschnitt der Gaslanze in einem Aufsatzteil angeordnet, welches auf den Hauptabschnitt der Gaslanze aufsetzbar ist. Auf diese Weise ist nicht nur die Tendenz zur Anhaftung von SiOx-Schichten an der Gaslanze im Bereich der Austrittsöffnung reduziert, sondern falls die im Aufsatzteil angeordnete Austrittsöffnung so stark verschmutzt ist, dass sie nicht mehr zu säubern ist, kann das Aufsatzteil mit der Austrittsöffnung leicht ausgewechselt werden. Auf diese Weise können Unterbrechungen im Beschichtungsprozess zeitlich minimiert werden.

Vorzugsweise enthält das Aufsatzteil eine Manschette, die den Hauptabschnitt der Gaslanze umgreift und das Aufsatzteil auf dem Hauptabschnitt festlegt. Diese Festlegung kann durch einen Friktionsangriff oder auch durch ein Gewinde oder Bajonettverschluss oder andere an sich bekannte lösbare Verbindungstechniken gebildet sein.

Vorzugsweise entspricht der Innendurchmesser des Aufsatzteils an seinem dem Hauptabschnitt der Gaslanze zugewandten Ende dem Innendurchmesser des Hauptabschnitts der Gaslanze. Auf diese Weise entsteht an der Verbindung zwischen Hauptabschnitt und Aufsatzteil der Gaslanze keine Kante, die für Verwirbelungen sorgen könnte und damit zu einer erhöhten Abscheidung der Reaktionsprodukte aus der Gasentladung, wie bspw. von SiOx an der Innenwand bzw. im Bereich der Austrittsöffnung.

Vorzugsweise fluchten die Innenwand des Aufsatzteils und die Innenwand des Hauptabschnitts der Gaslanze an ihren einander zugewandten Enden. Dies führt nicht nur dazu, dass keine Stufe an der Verbindungsstelle vorhanden ist, sondern die Steigung der Wand ist ebenmäßig, womit kein Knick in der Wandung vorhanden ist, die ebenfalls wieder zu Verwirbelungen des zugeführten Gases führen könnte. Der Innendurchmesser der Innenwand des Hauptabschnitts geht somit glatt ohne Stufe, Kante oder Knick in die Innenwandung des Aufsatzteils über, dessen Innendurchmesser im Bereich der Austrittsöffnung gegenüber dem Innendurchmesser des Hauptabschnitts der Gaslanze erweitert ist.

Vorzugsweise ist die Beschichtungsvorrichtung als Massenbeschichtungsanlage mit einer Beschichtungskapazität von wenigstens 1.000, insbesondere wenigstens 10.000 Behältern pro Stunde ausgebildet. Die Beschichtungsvorrichtung beinhaltet nicht nur die Vakuumkammer, die Aufnahmen für die Behälter, insbesondere PET-Flaschen, sondern auch die gesamten Bewegungsmechanismen und Roboter, die die Flaschen in der Vakuumkammer über der Gaslanze anordnen. Selbstverständlich kann in diesem Verfahren auch die Gaslanze axial in den Behälter hineinbewegt werden. Die Beschichtungsvorrichtung ist insbesondere konzipiert zur SiOx-Beschichtung von PET-Flaschen, kann jedoch auch zur Beschichtung mit anderen Materialien verwendet werden, zum Beispiel zur Sterilisierung oder Hygienebehandlung bzw. Antifungizidbehandlung etc.

In einer vorteilhaften Weiterbildung der Erfindung ist die die Austrittsöffnung umgebende Endkante der Gaslanze abgerundet. Dies führt zu einer verringerten Neigung der Anlagerung von SiOx-Schichten an dieser Endkante und somit zu einer verminderten Neigung des Zuwachsens der Austrittsöffnung durch angelagerte SiOx-Schichten. Dies wiederum verlängert die Serviceintervalle und ermöglicht somit längere ununterbrochene Arbeitszyklen.

Vorzugsweise ist die die Austrittsöffnung umgebende Endkante der Gaslanze nach außen umgebördelt, was wiederum die Tendenz zur Anlagerung von SiOx-Schichten vermindert.

Es ist für den Fachmann selbstverständlich, dass die oben angegebenen Ausführungsformen miteinander kombinierbar sind. In einer Massenbeschichtungsvorrichtung können natürlich viele Vakuumkammern und viele Gaslanzen angeordnet sein, um chargenweise oder kontinuierlich eine Vielzahl von Behältern, insbesondere PET-Flaschen, gleichzeitig zu beschichten.

In der Regel wird in der Beschichtungsvorrichtung die Gaslanze von unten senkrecht nach oben in den Behälter, insbesondere die PET-Flasche, hineingeschoben. Es ist jedoch auch jede andere Ausrichtung der Gaslanze in der Vakuumkammer möglich. Es ist weiterhin möglich, die Gaslanze während des Beschichtungsvorgangs stationär zu halten oder während des Beschichtungsvorgangs in den Behälter hinein bzw. aus dem Behälter hinaus zu bewegen.

Vorzugsweise ist der Innendurchmesser im Hauptabschnitt der Gaslanze konstant.

Die Erfindung wird nachfolgend beispielsweise anhand der schematischen Zeichnung beschrieben. In dieser zeigen:
Fig. 1a eine Draufsicht auf eine rotative Beschichtungsvorrichtung, bei der die Vakuumkammern immer zwei Behälter aufnehmen und behandeln können,
Fig. 1b einen seitlichen Schnitt durch eine Vakuumkammer einer Beschichtungsvorrichtung und einer Gaslanze und einem Mikrowellengenerator,
Fig. 2 eine detaillierte Ansicht des oberen Endes der Gaslanze aus Fig. 2 in einer ersten Ausführungsform,
Fig. 3 eine detaillierte Abbildung des oberen Endes der Gaslanze aus Fig. 1 in einer zweiten Ausführungsform,
Fig. 4 eine geschnittene vertikale Querschnittsansicht einer dritten Ausführungsform des oberen Endes der Gaslanze mit einem Aufsatzteil, welches die Austrittsöffnung aufweist, und
Fig. 5 eine nicht erfindungsgemäße einfache Ausführungsform einer zylindrischen Gaslanze mit vergrößertem Innendurchmesser im Endabschnitt.

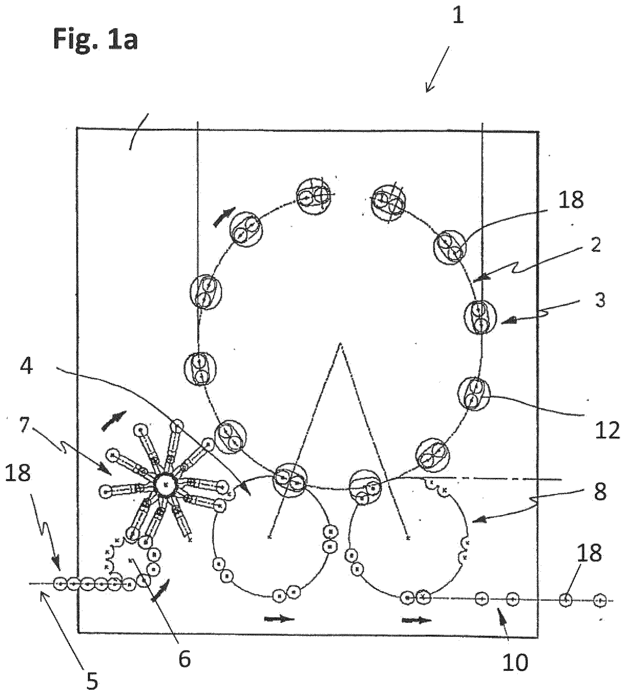

Fig. 1a zeigt eine rotative Beschichtungsvorrichtung 1, auf deren Transportrad 2 die umlaufenden Beschichtungsstationen 3 angeordnet sind, die die jeweils eine Vakuumkammer 12 umfassen, und wobei im gezeigten Beispiel immer zwei Behälter 18 aufgenommen und behandelt werden können. Die Zuleitungsstrecke 5 führt die stehend transportierten Behälter 18 an einen Abteilstern 6, durch welchen die Behälter 18 auf die erforderliche, gleichmäßige Beabstandung gebracht werden. Von dort werden die Behälter 18 paarweise von einem Greifelemente aufweisenden Transferstern 7 übernommen und einem Einführungsrad 4 übergeben. Vom Einführungsrad 4 werden die Behälter 18 dann paarweise in die nicht näher dargestellten Aufnahmeelemente der Vakuumkammer 12 geleitet und dort gehalten. In analoger weise werden behandelte Behälter 18 aus den Aufnahmeelementen wieder entlassen und die Behälter 18 über ein Ausleitrad 8 auf eine Ausleitstrecke 10 geleitet.

Hieran schließt sich stromabwärts üblicherweise eine nicht dargestellte Füllmaschine oder eine Vorrichtung zur Dekoration an, wie bspw. eine Etikettiermaschine oder eine Bedruckungsmaschine.

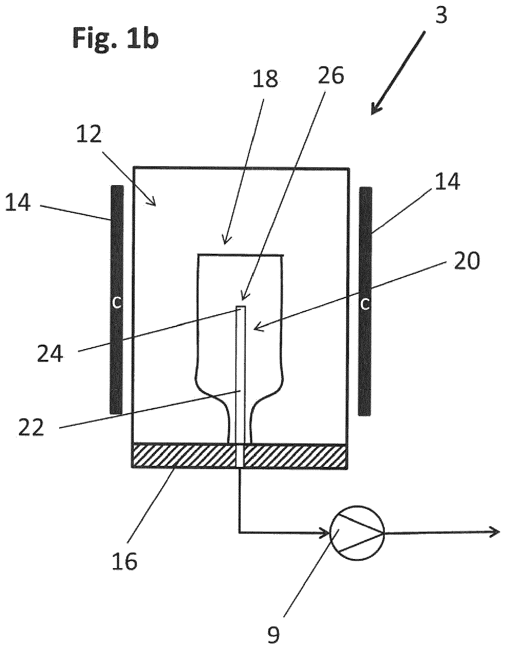

Fig. 1b zeigt sehr schematisch eine Vakuumkammer 12 der Beschichtungsvorrichtung 1, die von einem Mikrowellengenerator 14 umgeben ist. Auf einer Grundplatte 16 der Vakuumkammer 12 ist als Behälter 18 eine einzelne zu beschichtende PET-Flasche 18 gehalten, im Unterschied zu dem Ausführungsbeispiel nach Figur 1a. Über die sehr schematisch dargestellte Vakuumeinheit 9 wird die Vakuumkammer 12 auf den erforderlichen Innendruck gebracht. In die PET-Flasche 18 ragt eine Gaslanze 20 hinein. Die Gaslanze 20 hat einen ersten, den längeren axialen Teil der Gaslanze 20 bildenden Hauptabschnitt 22 und einen Endabschnitt 24, in welchem die Austrittsöffnung 26 angeordnet ist. Dieser Endabschnitt 24 der Gaslanze 20 bzw. dessen Innendurchmesser ist im Bereich zur Austrittsöffnung 26 hin erweitert, wie aus den nachfolgenden detaillierten Querschnittszeichnungen 2 bis 5 ersichtlich ist, die alternative Ausführungsformen der Gaslanze 20 aus Fig. 1a zeigen.

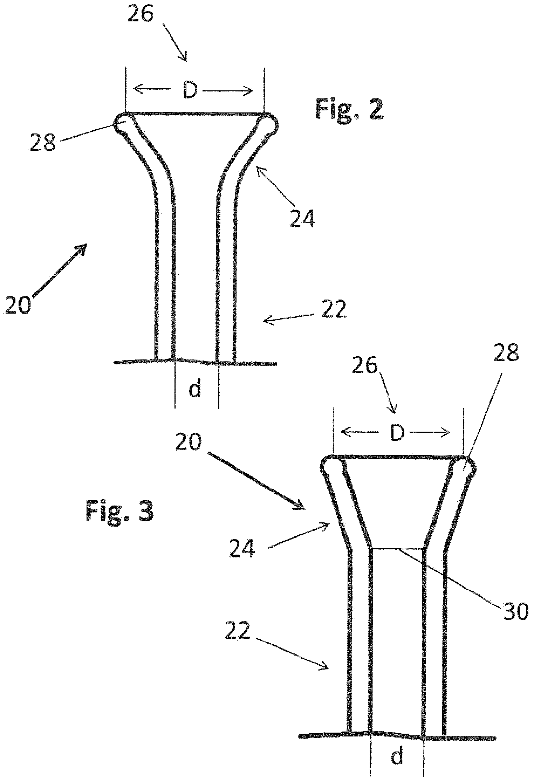

So ist der Endabschnitt 24 der Gaslanze 20 in Fig. 2 trompetenförmig aufgeweitet, so dass der Durchmesser D der Austrittsöffnung 26 mehr als doppelt so groß ist wie der Innendurchmesser d der Gaslanze 20 im Hauptabschnitt 22. Vorteilhaft an dieser Ausführungsform ist, dass die Innenfläche der Gaslanze 20 zwischen dem Hauptabschnitt 22 und dem Endabschnitt 24 glatt und abgerundet ist, so dass dort weder eine Stufe noch eine Kante vorhanden ist, an der Verwirbelungen auftreten können. Vorzugsweise ist daher die Innenfläche der Gaslanze 20 zwischen Hauptabschnitt 22 und Endabschnitt 24 glatt und rund ohne irgendwelche Kanten und Ecken. Die Endkante 28 des Endabschnitts 24 der Gaslanze 20, welche die Austrittsöffnung 26 umgibt, ist rund, was wiederum die Tendenz zur Anlagerung von SiOx-Schichten an der Endkante 28 verringert. Fig. 3 zeigt eine zu Fig. 2 weitgehend identische Ausführungsform. Hier jedoch ist der Endabschnitt 24 nicht trompetenförmig, sondern kegelförmig aufgeweitet, was eine kleine Kante 30 zwischen Hauptabschnitt 22 und Endabschnitt 24 der Gaslanze 20 schafft. Auch hier ist die Endkante 28 an der Austrittsöffnung 26 abgerundet und sogar etwas wulstförmig verdickt, was die Anlagerung von SiOx-Schichten an dieser Endkante 28 reduziert. Diese Ausführungsform ist maschinell leicht und kostengünstig herzustellen.

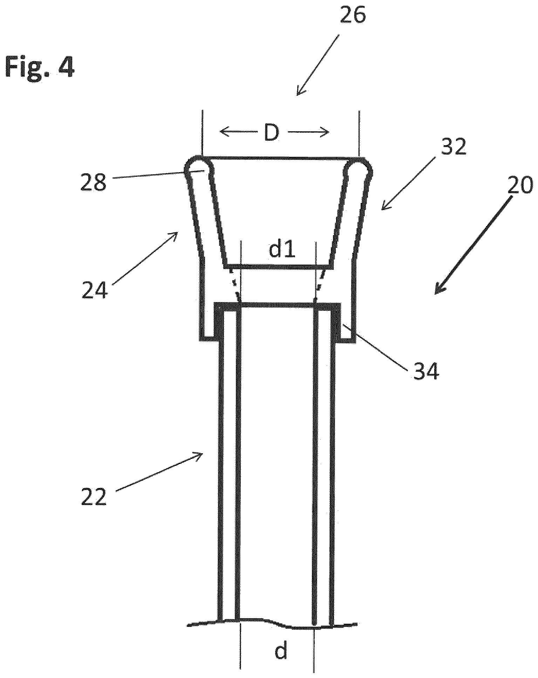

Eine weitere alternative Ausführungsform der Gaslanze 20 ist in Fig. 4 dargestellt. Hier ist der Hauptabschnitt 22 der Gaslanze 20 durch ein zylindrisches Rohr mit einem definierten Innendurchmesser d gebildet, an dessen freiem oberen Ende ein Aufsatzteil 32 aufgesetzt ist, welches eine Manschette 34 aufweist, die den Hauptabschnitt 22 der Gaslanze 20 umgreift, um das Aufsatzteil 32 auf dem Hauptabschnitt 22 festzulegen. Das Aufsatzteil 32 bildet hier sozusagen den Endabschnitt 24 der Gaslanze 20. Das Aufsatzteil 32 hat an seinem dem Hauptabschnitt 22 der Gaslanze 20 zugewandten Ende einen Innendurchmesser d1, der dem Innendurchmesser d des Hauptabschnitts 22 der Gaslanze 20 entspricht. Auf diese Weise entsteht im Innenbereich der Gaslanze 20 keine Stufe zwischen dem Hauptabschnitt 22 und dem Aufsatzteil 32. Das Aufsatzteil 32 ist kegelförmig aufgeweitet in gleicher Weise wie der Endabschnitt 24 der Fig. 3. Demgemäß ist der Durchmesser D an der Austrittsöffnung 26 des Aufsatzteils 32 in etwa doppelt so groß wie der Innendurchmesser d des Hauptabschnitts 22 der Gaslanze 20. Das Aufsatzteil 32 kann mittels der Manschette 34 über Friktionsangriff oder andere Verbindungsarten, wie z.B. Schraubgewinde oder Bajonettgewinde, an dem Hauptabschnitt 22 gehalten sein.

Die Manschette 34 kann alternativ oder zusätzlich auch die Innenwand des rohrförmigen Hauptabschnittes 22 umgreifen. Hier könnte dann die Wandstärke des Hauptabschnitts 22 an der Innenseite reduziert sein, so dass aufgrund des Hintergreifens des Rohres der Gaslanze 20 durch die Manschette 34 der Innendurchmesser d der Gaslanze 20 nicht verringert wird, und zusätzlich keine Stufe erzeugt wird, an der Verwirbelungen des Beschichtungsgases, insbesondere Prozessgas, wie bspw. Siloxan-Gases, auftreten können.

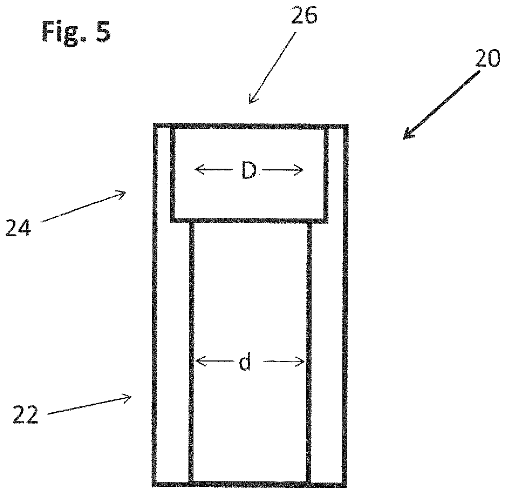

Schließlich zeigt Fig. 5 eine sehr einfache Ausführungsform, bei welcher der Endabschnitt 24 der Gaslanze 20 gegenüber dem Hauptabschnitt 22 einfach einen Innendurchmesser D aufweist, der größer als er Innendurchmesser d der Gaslanze 20 im Hauptabschnitt 22 der Gaslanze 20 ist. Wenngleich die strömungstechnischen Eigenschaften nicht so gut sind wie bei den vorherigen Ausführungsformen, führt auch diese Ausführungsform zu einer verminderten Anlagerung von SiOx-Schichten an der Austrittsöffnung 26.

Es ist selbstverständlich, dass die oben beschriebenen Ausführungsformen den Grundgedanken der Erfindung nicht einschränken. Dieser kann im Rahmen der nachfolgenden Ansprüche variiert werden.

Zum Beispiel kann die Idee des erweiterten Durchmessers des Endabschnitts 24 der Gaslanze 20 gegenüber dem Hauptabschnitt 22 (Fig. 5) kombiniert werden mit einer nachfolgenden erfindungsgemäßen kegelförmigen oder trompetenförmigen Erweiterung des Endabschnitts 24, wie dies in den Fig. 2 und 3 dargestellt ist. Somit können die Ausführungsformen der Fig. 5, 2 und 3 kombiniert werden. Insbesondere kann eine der vorstehenden Ausführungsformen in Beschichtungsstationen auf Vorrichtungen gem. der DE 10 2010 023119 A1 oder auch der EP 1 507 893 B1 zur Anwendung kommen oder auch in linearen Beschichtungsvorrichtungen.

### Bezugszeichenliste

- 1: Beschichtungsvorrichtung
- 2: Transportrad
- 3: Beschichtungsstation
- 4: Einführungsrad
- 5: Zuleitungsstrecke
- 6: Abteilstern
- 7: Transferstern
- 8: Ausleitrad
- 9: Vakuumeinheit
- 10: Ausleitstrecke
- 12: Vakuumkammer
- 14: Mikrowellengenerator - Plasmagenerator
- 16: Grundplatte
- 18: Behälter - PET-Flasche
- 20: Gaslanze (z.B. zur Prozessgas-, wie bspw. Slioxan-, Zufuhr)
- 22: Hauptabschnitt der Gaslanze
- 24: Endabschnitt der Gaslanze
- 26: Austrittsöffnung
- 28: Endkante um die Austrittsöffnung
- 30: Kante zwischen Hauptabschnitt und Endabschnitt
- 32: Aufsatzteil
- 34: Manschette

- D: Innendurchmesser im Bereich der Austrittsöffnung
- d: Innendurchmesser im Hauptabschnitt
- d1: Innendurchmesser des Aufsatzteils

## Patentansprüche

1. Vorrichtung (1) zur Beschichtung von Behältern (18), umfassend eine Vakuumkammer (12), einen Plasmagenerator (14) und eine Gaslanze (20) mit einer Austrittsöffnung (26) an deren Endabschnitt (24), die im bestimmungsgemäßen Betrieb in den Behälter (18) hinein ragt und zur Einbringung eines auf der Innenwand des Behälters (18) abzuscheidenden Materials und als Antenne für die elektromagnetische Feldorientierung in der Vakuumkammer dient, wobei der Innendurchmesser (D) der Gaslanze (20) im Bereich der Austrittsöffnung (26) relativ zu dem Innendurchmesser (d) in einem Hauptabschnitt (22) der Gaslanze (20) vergrößert ist, **dadurch gekennzeichnet, dass** die Gaslanze (20) im Bereich der Austrittsöffnung (26) trompetenförmig oder kegelförmig aufgeweitet ist.

2. Vorrichtung (1) nach Anspruch 1, **dadurch gekennzeichnet, dass** der Behälter (18) aus einem Kunststoff, wie beispielsweise PP, PE oder PET, ist.

3. Vorrichtung (1) nach einem der vorhergehenden Ansprüche, **dadurch gekennzeichnet, dass** die Gaslanze (20) im Bereich der Austrittsöffnung (26) aus einem anderen Material besteht als in einem Hauptabschnitt (22).

4. Vorrichtung (1) nach einem der vorhergehenden Ansprüche, **dadurch gekennzeichnet, dass** die Gaslanze (20) zumindest teilweise aus Edelstahl besteht.

5. Vorrichtung (1) nach einem der vorhergehenden Ansprüche, **dadurch gekennzeichnet, dass** die Gaslanze (20) zumindest teilweise aus Al₂O₃ besteht.

6. Vorrichtung (1) nach einem der vorhergehenden Ansprüche, **dadurch gekennzeichnet, dass** die Gaslanze (20) an der Austrittsöffnung (26) einen Durchmesser (D) aufweist, der wenigstens zweimal so groß ist wie der Innendurchmesser (d) eines Hauptabschnitts (22) der Gaslanze (20).

7. Vorrichtung (1) nach einem der vorhergehenden Ansprüche, **dadurch gekennzeichnet, dass** der aufgeweitete Teil der Gaslanze (20) in einem Aufsatzteil (32) angeordnet ist, welches auf dem Hauptabschnitt (22) der Gaslanze (20) austauschbar gehalten ist.

8. Vorrichtung (1) nach Anspruch 7, **dadurch gekennzeichnet, dass** das Aufsatzteil (32) eine Manschette (34) aufweist, die den Hauptabschnitt (22) umgreift und das Aufsatzteil (32) auf dem Hauptabschnitt (22) festlegt.

9. Vorrichtung (1) nach Anspruch 7 oder 8, **dadurch gekennzeichnet, dass** der Innendurchmesser (d1) des Aufsatzteils (32) an seinem dem Hauptabschnitt (22) der Gaslanze (20) zugewandten Ende dem Innendurchmesser (d) des Hauptabschnitts (22) der Gaslanze (20) entspricht.

10. Vorrichtung (1) nach Anspruch 9, **dadurch gekennzeichnet, dass** die Orientierung der Innenwand des Aufsatzteils (32) mit der Innenwand des Hauptabschnitts (22) der Gaslanze (20) an ihren einander zugewandten Enden fluchtet.

11. Vorrichtung (1) nach einem der vorhergehenden Ansprüche, welche als Massenbeschichtungsanlage mit einer Beschichtungskapazität von wenigstens 1.000, insbesondere wenigstens 10.000 Behältern (18) pro Stunde ausgebildet ist.

12. Vorrichtung (1) nach einem der vorhergehenden Ansprüche, **dadurch gekennzeichnet, dass** der Plasmagenerator (14) ein Mikrowellengenerator ist.

13. Vorrichtung (1) nach einem der vorhergehenden Ansprüche, **dadurch gekennzeichnet, dass** die Endkante (28) der Gaslanze (20) an der Austrittsöffnung (26) abgerundet ist.

14. Vorrichtung (1) nach einem der vorhergehenden Ansprüche, **dadurch gekennzeichnet, dass** die Endkante (28) der Gaslanze (20) an der Austrittsöffnung (26) nach außen umgebördelt ist.

15. Vorrichtung (1) nach einem der vorhergehenden Ansprüche, **dadurch gekennzeichnet, dass** die Gaslanze (20) mehrteilig ausgebildet ist, wobei ein Endabschnitt (24) die Austrittsöffnung (26) aufweist und ein Hauptabschnitt (22) den axial größeren Teil der Gaslanze (20) bildet, insbesondere ist der Endabschnitt (24) vorzugsweise auswechselbar auf dem Hauptabschnitt (22) gehalten.

## Claims

1. Device (1) for coating containers (18), comprising a vacuum chamber (12), a plasma generator (14) and a gas lance (20) having an outlet opening (26) in its end section (24) and protruding into the container (18) during normal operation and serving to introduce a material to be deposited on the inner wall of the container (18) and as an antenna for electromagnetic field orientation in the vacuum chamber, wherein the internal diameter (D) of the gas lance (20) in the region of the outlet opening (26) is enlarged relative to the internal diameter (d) in a main section (22) of the gas lance (20), **characterized in that** the gas lance (20) is widened in the shape of a trumpet or cone in the region of the outlet opening (26).

2. Device (1) according to claim 1, **characterized in that** the container (18) is made of a plastic, such as for example PP, PE or PET.

3. Device (1) according to one of the preceding claims, **characterized in that** the gas lance (20) in the region of the outlet opening (26) consists of a different material from that in a main section (22).

4. Device (1) according to one of the preceding claims, **characterized in that** the gas lance (20) consists at least partly of stainless steel.

5. Device (1) according to one of the preceding claims, **characterized in that** the gas lance (20) consists at least partly of Al₂O₃.

6. Device (1) according to one of the preceding claims, **characterized in that** the gas lance (20) has a diameter (D) at the outlet opening (26) which is at least twice as large as the internal diameter (d) of a main section (22) of the gas lance (20).

7. Device (1) according to one of the preceding claims, **characterized in that** the widened part of the gas lance (20) is arranged in an attachment part (32), which is held in a replaceable manner on the main section (22) of the gas lance (20).

8. Device (1) according to claim 7, **characterized in that** the attachment part (32) has a collar (34), which grips around the main section (22) and fixes the attachment part (32) on the main section (22).

9. Device (1) according to claim 7 or 8, **characterized in that** the internal diameter (d1) of the attachment part (32) at its end facing the main section (22) of the gas lance (20) corresponds to the internal diameter (d) of the main section (22) of the gas lance (20).

10. Device (1) according to claim 9, **characterized in that** the orientation of the inner wall of the attachment part (32) is aligned with the inner wall of the main section (22) of the gas lance (20) at its ends facing each other.

11. Device (1) according to one of the preceding claims, which is formed as a mass coating system with a coating capacity of at least 1,000, in particular at least 10,000, containers (18) per hour.

12. Device (1) according to one of the preceding claims, **characterized in that** the plasma generator (14) is a microwave generator.

13. Device (1) according to one of the preceding claims, **characterized in that** the end edge (28) of the gas lance (20) is rounded at the outlet opening (26).

14. Device (1) according to one of the preceding claims, **characterized in that** the end edge (28) of the gas lance (20) is flanged outwardly at the outlet opening (26).

15. Device (1) according to one of the preceding claims, **characterized in that** the gas lance (20) is formed in several parts, wherein an end section (24) has the outlet opening (26) and a main section (22) forms the axially larger part of the gas lance (20), in particular the end section (24) is preferably held in an exchangeable manner on the main section (22).

## Revendications

1. Dispositif (1) pour le revêtement de contenants (18), comprenant une chambre sous vide (12), un générateur de plasma (14) et une lance à gaz (20) avec une ouverture de sortie (26) au niveau de sa section d'extrémité (24) qui rentre dans les contenants (18) en situation de fonctionnement conforme à sa destination et pour l'apport de matière à couper sur la paroi intérieure du contenant (18) et servant d'antenne pour l'orientation du champ électromagnétique dans la chambre sous vide, le diamètre intérieur (D) de la lance à gaz (20) étant agrandi dans la région de l'ouverture de sortie (26) par rapport au diamètre intérieur (d) dans une section principale (22) de la lance à gaz (20), **caractérisé en ce que** la lance à gaz (20) est évasée en trompette ou en cône dans la région de l'ouverture de sortie (26).

2. Dispositif (1) selon la revendication 1, **caractérisé en ce que** le contenant (18) est fabriqué en matière plastique, par exemple en PP, en PE ou en PET.

3. Dispositif (1) selon l'une quelconque des revendications précédentes, **caractérisé en ce que** dans la région de l'ouverture de sortie (26), la lance à gaz (20) se compose d'une autre matière que dans une section principale (22).

4. Dispositif (1) selon l'une quelconque des revendications précédentes, **caractérisé en ce que** la lance à gaz (20) est au moins en partie en inox.

5. Dispositif (1) selon l'une quelconque des revendications précédentes, **caractérisé en ce que** la lance à gaz (20) est au moins en partie en Al₂O₃.

6. Dispositif (1) selon l'une quelconque des revendications précédentes, **caractérisé en ce que** la lance à gaz (20) présente au niveau de l'ouverture de sortie (26) un diamètre (D) au moins deux fois aussi grand que le diamètre intérieur (d) d'une section principale (22) de la lance à gaz (20).

7. Dispositif (1) selon l'une quelconque des revendications précédentes, **caractérisé en ce que** la partie évasée de la lance à gaz (20) est disposée dans une partie chapeau (32) maintenue de façon amovible sur la section principale (22) de la lance à gaz (20).

8. Dispositif (1) selon la revendication 7, **caractérisé en ce que** la partie chapeau (32) comporte un manchon (34) enceignant la section principale (22) et fixant la partie chapeau (32) sur la section principale (22).

9. Dispositif (1) selon la revendication 7 ou 8, **caractérisé en ce que** le diamètre intérieur (d1) de la partie chapeau (32) correspond, au niveau de son extrémité orientée vers la section principale (22) de la lance à gaz (20), au diamètre intérieur (d) de la section principale (22) de la lance à gaz (20).

10. Dispositif (1) selon la revendication 9, **caractérisé en ce que** l'orientation de la paroi intérieure de la partie chapeau (32) est alignée avec la paroi intérieure de la section principale (22) de la lance à gaz (20) au niveau de ses extrémités orientées l'une vers l'autre.

11. Dispositif (1) selon l'une quelconque des revendications précédentes, ledit dispositif étant réalisé sous la forme d'une installation de revêtement de masse avec une capacité de revêtement d'au moins 1000, notamment d'au moins 10 000 contenants (18) par heure.

12. Dispositif (1) selon l'une quelconque des revendications précédentes, **caractérisé en ce que** le générateur de plasma (14) est un générateur de micro-ondes.

13. Dispositif (1) selon l'une quelconque des revendications précédentes, **caractérisé en ce que** l'arête d'extrémité (28) de la lance à gaz (20) est arrondie au niveau de l'ouverture de sortie (26).

14. Dispositif (1) selon l'une quelconque des revendications précédentes, **caractérisé en ce que** l'arête d'extrémité (28) de la lance à gaz (20) est bordée vers l'extérieur au niveau de l'ouverture de sortie (26).

15. Dispositif (1) selon l'une quelconque des revendications précédentes, **caractérisé en ce que** la lance à gaz (20) est réalisée en plusieurs parties, une section d'extrémité (24) comportant l'ouverture de sortie (26) et une section principale (22) formant la partie de la lance à gaz (20) la plus grande dans le plan axial, la section d'extrémité (24) étant notamment maintenue de préférence de façon amovible sur la section principale (22).
